# EUROPEAN PATENT APPLICATION

(11) **EP 1 502 930 A1**
(43) Date of publication of application: **02.02.2005**
(21) Application number: 03017025.2
(22) Date of filing: 26.07.2003
(51) Int. Cl.: C08K 3/22, C08G 59/00, H01F 1/34, H01F 27/24

(54) **Epoxy resin of electromagnetic interference suppression and manufacturing method thereof and an inductor applied in the electromagnetic interference suppression**

(71) Applicant: ABC Taiwan Electronics Corp., Taoyuan Hsien (TW)
(72) Inventor: Hsu, Chaby, Taoyuan Hsien (TW)
(74) Representative: Reichel, Wolfgang, Dipl.-Ing.

(57) **Abstract**

An epoxy resin of electromagnetic interference (EMI) suppression includes a ferrite and an epoxy. The EMI epoxy resin can be hardened quickly, has great resistance to heat and has great resistance to acid and alkaline. Thus, the EMI epoxy resin can be directly coated on the high frequency response member of the communication equipment to prevent interference of noise in the air. In addition, the EMI epoxy resin can be applied on package of the inductor to enhance the feature of the inductor, so that the inductance of the inductor can be enhanced by at least two times.

## Description

The present invention relates to an epoxy resin of electromagnetic interference (EMI) suppression and the manufacturing method thereof and an inductor applied in the electromagnetic interference suppression.

For the compact electronic members of high speed operation, the electromagnetic interference (EMI) suppression, radio frequency interference (RFI) suppression and electrostatic discharge (ESD) suppression are very important. In addition, the compact electronic members are easily interfered by the electronic noise and broken by the electrostatic discharge, so that the compact electronic members need the electromagnetic shield and electrostatic protection. In addition, the compact electronic members need the electrostatic protection material during fabrication, storage and transportation to prevent the electrostatic voltage from affecting the normal operation of the compact electronic members.

In general, the high molecular material is an excellent insulator whose surface resistance,is greater than 1012Ω/cm², so that the charges easily concentrate on the surface of the high molecular material. Thus, the high molecular material can be added with conductive pack (such as conductive carbon or metallic powder) or antistatic solution to prevent the charges from concentrating on the surface of the high molecular material.

The conductive high molecular material can be used in four parts including:
1. the antistatic material which is used in the package material;
2. the ESD protection which is used in the package material or operation tool;
3. the EMI/RFI shield which is used in the shell of the electronic information and communication and applied in the static protection under the high voltage; and
4. the conductive connection which is applied in the conductive paint, silver paste or hetero conductive voltage.

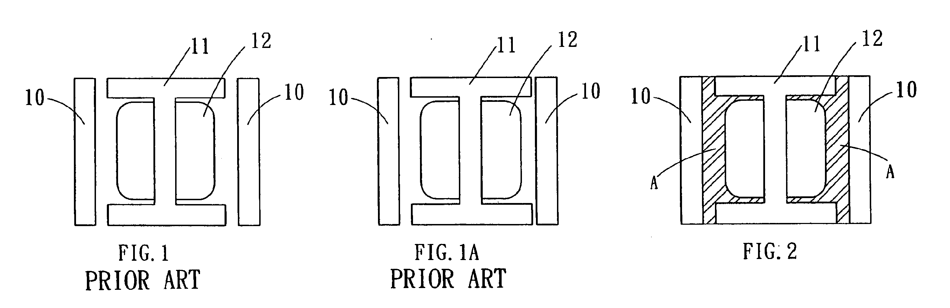

A conventional close magnetic inductor in accordance with the prior art shown in Figs. 1 and 1A comprises a drum core (DR core) 11, a ring core (RI core) 10, and a wiring 12. As shown in Fig. 1A, when the DR core 11 is tilt during assembly, one side of the DR core 11 is closer to the RI core 10, so that the inductance is increased slightly.

The present invention is to provide an inductor that is made of ferrite. The ferrite material has the function of electromagnetic interference (EMI) suppression. Thus, the present invention uses the ferrite material to make the epcxy resin with the function of EMI suppression so as to replace the inductor made of iron. The iron is not available for an inductor due to its conductive feature. Thus, the non-conductive material-- ferrite can be added with proper epoxy to make the resin material for package. In general, when a close magnetic inductor is added with the EMI epoxy resin, the inductance is enhanced, so as to improve other features of the inductor, such as RDC (direct current resistance), IDC, Q value (quality value), tolerance or the like.

According to the prevent invention, the components of the inductor include a ferrite and an epoxy. The sintered powder of the ferrite is mortared, and is added with the epoxy which functions as the binder. The initial permeability of the ferrite is greater than 250 (µi>250), and the diameter of the powder of the ferrite is smaller than 0.35 (φ <0.35). Thus, the fine powder will entirely shield the electromagnetic waves to prevent the electromagnetic interference. The epoxy includes two parts, that is, bisphenol A and epichlorohydrin to make the universal epoxy having an epoxy equivalent weight (EEW) ranged between 185 and 195. The hardener adopts the modified amine whose amine value is 170±20. In such a manner, the epoxy and the hardener are added into the powder of the ferrite, and the mixture is stirred evenly, thereby making the EMI epoxy resin that can prevent electromagnetic interference.

In the inductor, in comparison with the close magnetic coil and the open magnetic coil, the inductance and Q value of the close magnetic coil are greater than that of the open magnetic coil, while the electronic resistance of current of the close magnetic coil is smaller than that of the open magnetic coil. Fabrication of the shielded close magnetic inductor has to consider the following technology:
1. The drum core (DR core) has to be located at the center of the ring core (RI core);
2. The wiring requires flatness; and
3. Assembly of the parts requires entire seal.

According to the prevent invention, the ferrite material of the EMI epoxy resin entirely eliminates interference of the air layer, and the EMI epoxy resin has the function of the binder, so that when the EMI epoxy resin is packed into the center of the DR core and the RI core, it is unnecessary to consider the position and seal of the DR core and the RI core.

In accordance with a first feature of the present invention, there is provided an epoxy resin of electromagnetic interference suppression, comprising a ferrite and an epoxy.

In accordance with a second feature of the present invention, there is provided a manufacturing method of an epoxy resin of electromagnetic interference suppression comprising the steps of:
preparing ferrite powder;
placing the ferrite powder into a ball mill jug to mix with water and a dispersant to form an evenly mixed slurry;
drying the slurry to form a sediment;
crashing the sediment by a mesh;
sintering the sediment to obtain magnetic ferrite powder having the electromagnetic interference (EMI) suppression function;
placing the sintered ferrite powder into a ball mill jug to be mortared at a lower speed;
frying the ferrite powder and crashing the ferrite powder by a mesh; and
mixing and evenly stirring the ferrite powder with an epoxy, a hardener and a dispersant to make the EMI epoxy resin consisting of the ferrite and the epoxy.

In accordance with a third feature of the present invention, there is provided a close magnetic inductor of electromagnetic interference suppression, comprising:
a drum core (DR core);
a ring core (RI core);
a wiring; and
an electromagnetic interference epoxy resin packed between the drum core and the ring core;
the electromagnetic interference epoxy resin including a ferrite and an epoxy.

In accordance with a fourth feature of the present invention, there is provided an open magnetic inductor of electromagnetic interference suppression, comprising:
an E-type ring core (ER core);
a surface mount bead type core (SB core);
a wiring; and
an electromagnetic interference epoxy resin packed between the E-type ring core and the surface mount bead type core and packed on a local surface of the wiring;
the electromagnetic interference epoxy resin including a ferrite and an epoxy.

In accordance with a fifth feature of the present invention, there is provided an inductor of electromagnetic interference suppression, comprising:
a wiring; and
an electromagnetic interference epoxy resin packed on a surface of the wiring;
the electromagnetic interference epoxy resin including a ferrite and an epoxy.

In the drawings:
Fig. 1 is a schematic plan view of a conventional close magnetic inductor in accordance with the prior art;
Fig. 1A is a schematic plan operational view of the conventional close magnetic inductor in accordance with the prior art;
Fig. 2 is a schematic plan view of a close magnetic inductor in accordance with the preferred embodiment of the present invention;
Fig. 3 is a schematic plan view of an open magnetic inductor in accordance with the preferred embodiment of the present invention;
Fig. 4 is a schematic plan view of a direct package type inductor in accordance with the preferred embodiment of the present invention;
Fig. 5 is a schematic plan view of a direct package type inductor in accordance with another embodiment of the present invention;
Fig. 6 is a schematic plan view of a direct package type inductor in accordance with a further embodiment of the present invention;
Fig. 7 is a schematic plan view of a RH 0910 type inductor (that is a product of ABC corporation) in accordance with the present invention;
Fig. 8 is a schematic plan view of a SH 5028 type inductor (that is a product of ABC corporation) in accordance with the present invention;
Fig. 9 is a schematic plan view of a SS 0603 type inductor (that is a product of ABC corporation) in accordance with the present invention;
Fig. 10 is a table showing testing results of the RH 0910 type inductor in accordance with the present invention;
Fig. 11 is a table showing testing results of the SH 5028 type inductor in accordance with the present invention;
Fig. 12 is a table showing testing results of the SS 0603 type inductor in accordance with the present invention; and
Fig. 13 is a table showing comparison of the RH 0910 type inductor, the SH 5028 type inductor and the SS 0603 type inductor in accordance with the present invention.

Referring to the drawings and initially to Fig. 2, a close magnetic inductor in accordance with the preferred embodiment of the present invention comprises a drum core (DR core) 11, a ring core (RI core) 10, a wiring 12, and an EMI epoxy resin "A" packed between the DR core 11 and the RI core 10. The EMI epoxy resin "A" includes a ferrite and an epoxy. Thus, the inductor is an entirely close magnetic member whose inductance is increased by at least two times. The increased rate of inductance is determined by the distance between the upper side (or lower side) of the DR core 11 and the wall of the RI core. 10. If the distance is smaller, the inductance is increased , and if the distance is greater, the inductance is even more increased.

In such a manner, the ferrite can increase the unit volume of the inductor so as to enhance the inductance. Preferably, the initial permeability of the ferrite is greater than 250 (µi>250), so that the inductor is an entirely close magnetic member, to prevent leakage of magnetic lines of the inductor from decreasing stability of the product.

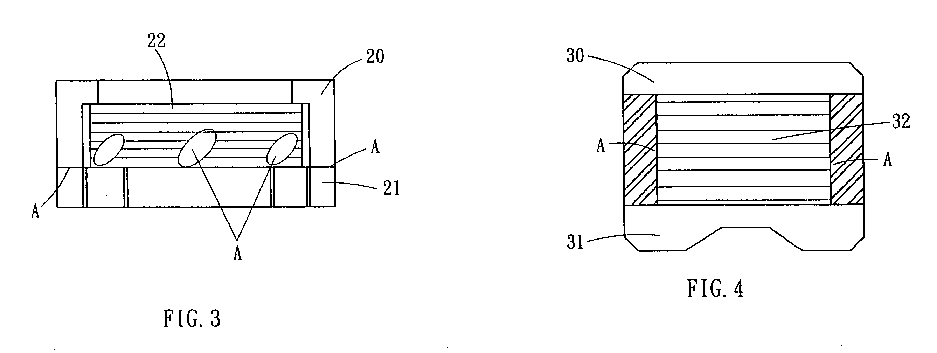

Referring to Fig. 3, an open magnetic inductor in accordance with the preferred embodiment of the present invention comprises an E-type ring core 20, a surface mount bead type core 21, a wiring 22, and an EMI epoxy resin "A" packed between the E-type ring core 20 and the surface mount bead type core 21 and packed on a local surface of the wiring 22. The EMI epoxy resin "A" includes a ferrite and an epoxy.

Referring to Fig. 4, a direct package type inductor in accordance with the preferred embodiment of the present invention comprises a drum core (DR core) 30, a terminal 31, a wiring 32, and an EMI epoxy resin "A" mounted on a surface of the wiring 32 in a bonding or filling manner. The EMI epoxy resin "A" includes a ferrite and an epoxy.

In comparison, the RI core of the conventional inductor is made by a sintering process, and is combined with other parts to form the conventional inductor, so that the costs of fabrication is great. According to the present invention, the EMI epoxy resin "A" consisting of the ferrite and epoxy is directly formed in a filling manner by a die to replace the RI core, thereby decreasing the costs of fabrication.

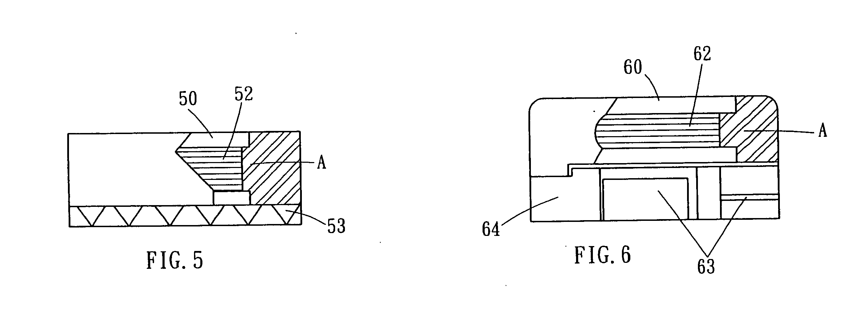

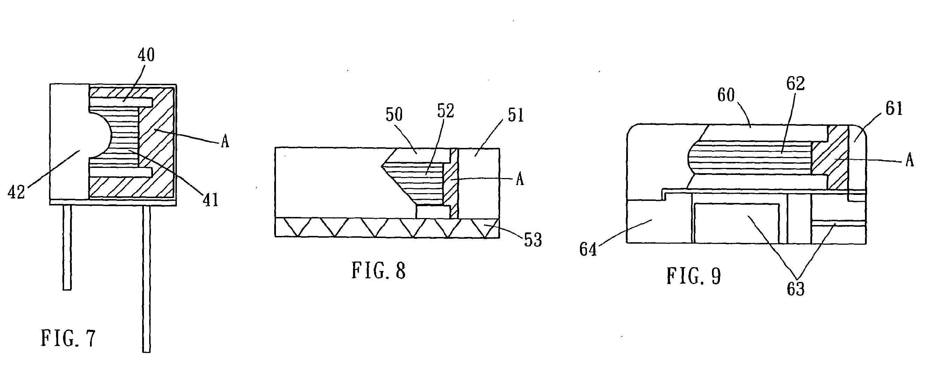

As shown in Figs. 5 and 6, the EMI epoxy resin "A" consisting of the ferrite and epoxy is directly filled and formed on the surface of the wiring 52 (or 62), so as to replace the RI core 51 (or 61) as shown in Figs. 8 and 9.

In addition, the conventional electronic member is provided with a copper plate or aluminum plate to package the element that will produce the electromagnetic waves. According to the present invention, the EMI epoxy resin "A" consisting of the ferrite and epoxy directly packages the element that will produce the electromagnetic waves without having to provide the copper plate or aluminum plate.

The manufacturing method of the EMI epoxy resin in accordance with the preferred embodiment of the present invention comprises the following steps:
1. Preparing ferrite powder (µi=700, Fe₂O₃=327.7g, NiO=32.7g, ZnO=108.5g, and CuO=34.5g) and placing the ferrite powder into a ball mill jug (containing ZrO₂ ball of 1Kg and φ =10) to mix with water of 400ml and a dispersant (BYK-111=2g) to form an evenly mixed slurry which is mortared during two hours;
2. Drying the slurry at a temperature of 120°C to form a sediment;
3. Crashing the sediment by a mesh (mesh=80) and sintering the sediment at a temperature of 900°C during three hours to obtain magnetic ferrite powder having the electromagnetic interference (EMI) suppression function;
4. Placing the sintered ferrite powder into a ball mill jug (containing ZrO₂ ball, and φ 30: φ 10: φ 3=2:3:5) to be mortared during 18 hours at a lower speed of 25rpm (the powder diameter<0.35µm);
5. Drying the ferrite powder and crashing the ferrite powder by a mesh (mesh=200); and
6. Mixing and evenly stirring the ferrite powder of 108g with an epoxy of 10g, a hardener of 2g (the ratio of the epoxy and the hardener is equal to 100 : 16 to 23) and a dispersant (BYK-111=1g) to make the EMI epoxy resin. At this time, the additive quantity of the epoxy is equal to 10 to 15%.

Referring to Fig. 7, a RH 0910 type inductor in accordance with the present invention comprises a drum core 40, a wiring 41, a housing 42 made of plastic bakelite, and an EMI epoxy resin "A" consisting of the ferrite and epoxy packed between the drum core 40 and the housing 42.

In the RH 0910 type inductor in accordance with the present invention, the difference between the open magnetic inductor and the close magnetic inductor is compared as follows:
1. Preparing a RH 0910 150Y inductor (12pcs);
2. filling an EMI epoxy resin "A" consisting of the ferrite and epoxy into between the drum core 40 and the housing 42 by a syringe and drying them at a temperature of 75°C during 20 minutes; and
3. taking out the dried inductor to measure its inductance so as to compare difference between the open magnetic inductor and the close magnetic inductor.

Referring to Fig. 8, a SH 5028 type inductor in accordance with the present invention comprises a drum core 50, a ring core 51, a wiring 52, terminals 53, and an EMI epoxy resin "A" consisting of the ferrite and epoxy packed between the drum core 50 and the ring core 51.

In the SH 5028 type inductor in accordance with the present invention, the difference between two close magnetic inductors is compared as follows:
1. Preparing the drum core 50 and the ring core 51 required for making the SH 5028 type inductor;
2. Fixing the drum core 50 in a wiring fixture (wound around 50 circles and 12pcs) to form twelve wound coils;
3. Packing the twelve wound coils in the ring core 51 by an adhesive tape to form a first close magnetic inductor and measuring the inductance of the first close magnetic inductor under the conditions of 1 volt and 1kHz;
4. filling the EMI epoxy resin "A" consisting of the ferrite and epoxy into the space between the drum core 50 and the ring core 51 by a syringe and drying them at a temperature of 75°C during 40 minutes to form a second close magnetic inductor; and
5. taking out the dried second close magnetic inductor to measure its inductance so as to compare difference between the first close magnetic inductor and the second close magnetic inductor.

Referring to Fig. 9, a SS 0603 type inductor in accordance with the present invention comprises a drum core 60, a ring core 61, a wiring 62, terminals 63, a base 64, and an EMI epoxy resin "A" consisting of the ferrite and epoxy packed between the drum core 60 and the ring core 61.

In the SS 0603 type inductor in accordance with the present invention, the difference between the magnetic inductors is compared as follows:
1. Preparing the drum core 60, the ring core 61 and the base 64 made of plastic bakelite required for making the SS 0603 type inductor;
2. Fixing the drum core 60 in a wiring fixture (wound around 23.5 circles and 12pcs) to form twelve wound coils;
3. Measuring the inductance of the twelve wound coils under the conditions of 1 volt and 1kHz, and then packing the twelve wound coils in the ring core 61 by an adhesive tape and measuring the inductance again so as to compare difference between the open magnetic inductor and the close magnetic inductor;
4. filling the EMI epoxy resin "A" consisting of the ferrite and epoxy into the space between the drum core 60 and the ring core 61 by a syringe and drying them at a temperature of 75°C during 40 minutes; and
5. taking out the dried coil of the magnetic inductor to measure its inductance so as to compare difference between the two close magnetic inductors.

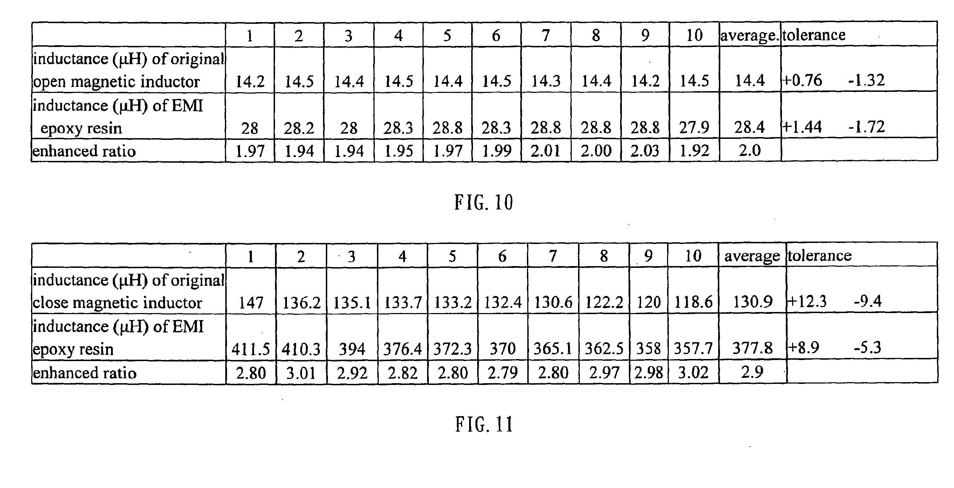

Fig. 10 is a table showing testing results of the RH 0910 type inductor in accordance with the present invention.

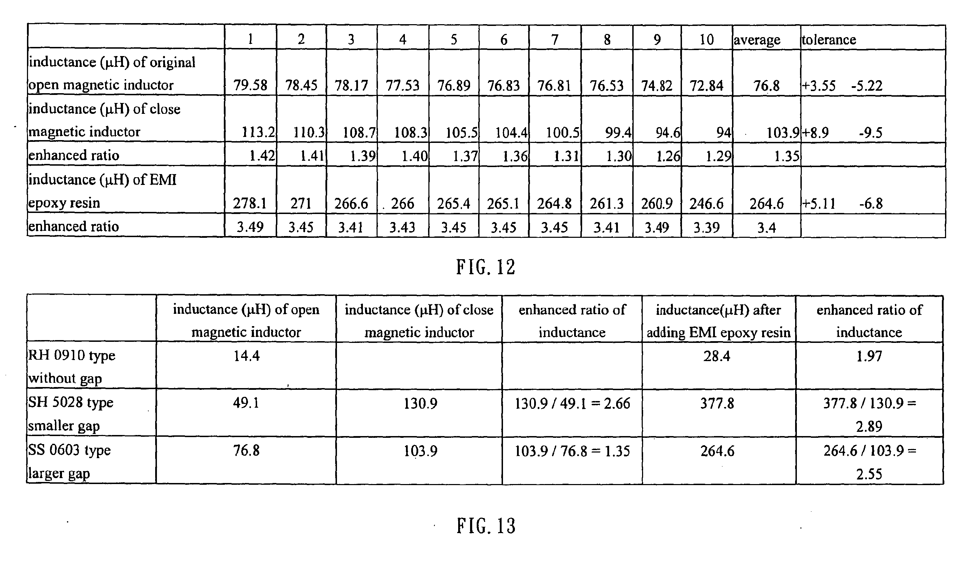

Fig. 11 is a table showing testing results of the SH 5028 type inductor in accordance with the present invention.

Fig. 12 is a table showing testing results of the SS 0603 type inductor in accordance with the present invention.

For the RH 0910 type inductor, the housing 42 made of plastic bakelite does not have the magnetic shield function. The EMI epoxy resin "A" consisting of the ferrite and epoxy is filled into the space between the drum core 40 and the housing 42 by a syringe to seal the wiring 41, so that the RH 0910 type inductor has the magnetic shield function. At the same time, the inductance of the close magnetic inductor is two times of that of the open magnetic inductor.

For the RH 0910 type inductor, the drum core contacts the housing closely. For the SH 5028 type inductor, a smaller gap is defined between the drum core and the ring core. For the SS 0603 type inductor, a larger gap is defined between the drum core and the ring core.

Fig. 13 is a table showing comparison of the RH 0910 type inductor, the SH 5028 type inductor and the SS 0603 type inductor. As shown in Fig. 13, when the ring core is mounted on the open magnetic inductor to form a close magnetic inductor, enhance of the inductance is largely decreased with increase of the gap even after the EMI epoxy resin is filled into the inductor. Thus, when the gap is increased, enhance of the inductance is decreased

When the EMI epoxy resin consisting of the ferrite and epoxy is packed into the inductor, the inductance of the inductor is enhanced.

Then, the following research is developed:
1. Making a small-sized inductor with supper high inductance;
2. Changing the diameter of the enameled copper wire under a determined requirement of inductance to enhance the feature of RDC and IDC; and
3. When the tolerance of the product is too great, the drum core having a smaller unit inductance can be used to decrease the tolerance (when the unit inductance of the magnetic material is increased, the error of the initial permeability µi is increased).

In general, when enhance of the inductance is too great (the magnetic field is larger), the electric field is limited greatly (the electronic resistance to current of the inductor is smaller). Thus, when the inductor having magnetic shield is designed, the unit inductance of the drum core is 0.3 times smaller than that of the ring core. When the EMI epoxy resin is used as the package material and the initial permeability of the ferrite is greater than 250 (µi>250), the electronic resistance to current of the inductor is decreased by at least one half. Thus, the initial permeability of the ferrite has to be smaller than 8 (µi<8) to improve the feature of the inductor.

## Claims

1. An epoxy resin of electromagnetic interference suppression, comprising a ferrite and an epoxy.

2. The epoxy resin of electromagnetic interference suppression in accordance with claim 1, wherein the ferrite has a proportion of 90 to 85%, and the epoxy has a proportion of 10 to 15%.

3. The epoxy resin of electromagnetic interference suppression in accordance with claim 1, wherein the ferrite has an initial permeability greater than 250 (µi>250) and has a powder diameter smaller than 0.35µm (φ <0.35µm).

4. A manufacturing method of an epoxy resin of electromagnetic interference suppression comprising the steps of:
preparing ferrite powder;
placing the ferrite powder into a ball mill jug to mix with water and a dispersant to form an evenly mixed slurry;
drying the slurry to form a sediment;
crashing the sediment by a mesh;
sintering the sediment to obtain magnetic ferrite powder having the electromagnetic interference (EMI) suppression function;
placing the sintered ferrite powder into a ball mill jug to be mortared at a lower speed;
frying the ferrite powder and crashing the ferrite powder by a mesh; and
mixing and evenly stirring the ferrite powder with an epoxy, a hardener and a dispersant to make the EMI epoxy resin consisting of the ferrite and the epoxy.

5. A close magnetic inductor of electromagnetic interference suppression, comprising:
a drum core;
a ring core;
a wiring; and
an electromagnetic interference epoxy resin packed between the drum core and the ring core;
the electromagnetic interference epoxy resin including a ferrite and an epoxy.

6. An open magnetic inductor of electromagnetic interference suppression, comprising:
an E-type ring core;
a surface mount bead type core;
a wiring; and
an electromagnetic interference epoxy resin packed between the E-type ring core and the surface mount bead type core and packed on a local surface of the wiring;
the electromagnetic interference epoxy resin including a ferrite and an epoxy.

7. An inductor of electromagnetic interference suppression, comprising:
a wiring; and
an electromagnetic interference epoxy resin packed on a surface of the wiring;
the electromagnetic interference epoxy resin including a ferrite and an epoxy.
